# EUROPEAN PATENT APPLICATION

(11) **EP 1 557 947 A1**
(43) Date of publication of application: **27.07.2005**
(21) Application number: 03754199.2
(22) Date of filing: 20.10.2003
(51) Int. Cl.: H03H 17/06

(54) **DIGITAL FILTER DESIGN METHOD AND DEVICE, DIGITAL FILTER DESIGN PROGRAM, AND DIGITAL FILTER**

(30) Priority: 21.10.2002 JP 2002306316
(71) Applicant: Neuro Solution Corp., Tokyo 158-0091 (JP)
(72) Inventor: KOYANAGI, Yukio, Saitama-shi, Saitama 336-0932 (JP)
(74) Representative: VOSSIUS & PARTNER
(86) International application number: PCT/JP2003/013382
(87) International publication number: WO 2004/036747

(57) **Abstract**

A symmetric unit filter (L10") is designed by combining in series two unit filters (1L10, 2L10) having asymmetric numerical sequences as filter coefficients (H1 to H3 and H4 to H6). Thus, by designing a filter by series connection, it is possible to automatically obtain a desired digital filter coefficient only by combining one type of unit filter (L10") in series. Moreover, a symmetric numerical sequence {-1 , 0, 9, 16, 9, 0, -1}/32 is divided at the center into two parts and one of them is used as the asymmetric filter coefficients (H1 to H3 and H4 to H6). This reduces the number of necessary taps, eliminates use of a window function, and prevents generation of a discretization error in the filter characteristic obtained.

## Description

### [Background of the Invention]

### [Field of the Invention]

The present invention relates to a digital filter designing method and device, digital filter designing program and digital filter, and more particularly, to an FIR filter and a method of designing it, which comprises a tapped delay line made up of a plurality of delayers and performs multiplying signals of the respective taps several-fold and then adding up the results of multiplication and outputting the addition result.

### [Description of the Related Art]

Some kind of digital signal processing is generally performed in various kinds of electronic devices provided in various fields of communication, measurement, sound/image signal processing, medical care, seismology, and so on. One of the most significant basic operation of the digital signal processing is filtering which extracts only a signal having a necessary frequency band from an input signal in which signal and noise are mixed. For this reason, digital filters are often used for electronic devices performing digital signal processing.

As the digital filter, an IIR (Infinite Impulse Response) filter and FIR (Finite Impulse Response) filter are often used. Of these digital filters, the FIR filter is a filter provided with tapped delay lines made up of a plurality of delayers, multiplies signals of the respective taps several-fold and adds up the results of multiplication and outputs the addition result, and has the following advantages. First, since extreme values of a transfer function of the FIR filter exist only at the origin of the z-plane, the circuit is always stable. Second, if filter coefficients are of a symmetric type, it is possible to realize a completely exact linear phase characteristic.

When filters are categorized from the standpoint of an arrangement of a pass band and a stop band, they are classified mainly into four categories of low-pass filters, high-pass filters, band pass filters and band elimination filters . The basic element for an IIR filter or FIR filter is a low-pass filter and other high-pass filter, band pass filter and band elimination filter are derived from the low-pass filter by carrying out processing such as frequency conversion.

By the way, the FIR filter uses impulse response expressed by a finite time length as a filter coefficient as is. Therefore, designing an FIR filter means determining filter coefficients so as to obtain a desired frequency characteristic.

Conventionally, when the low-pass filter as the basic element is designed, filter coefficients of an FIR filter with respect to the respective taps are obtained by carrying out convolutional calculations, etc. , using a window function or Chebyshev approximation, etc., based on the ratio of a sampling frequency and a cutoff frequency. Then, a simulation is performed using the obtained filter coefficients to correct the coefficient values as appropriate while checking the frequency characteristic to thereby obtain a low-pass filter having a desired characteristic.

Furthermore, when the other filters such as high-pass filter, band pass filter, band elimination filter are designed, a plurality of low-pass filters as the basic elements are designed using the above described procedure first. Next, by carrying out operations such as frequency conversion by combining those low-pass filters, an FIR filter having a desired frequency characteristic is designed.

However, the filter frequency characteristic obtained using the conventional design method depends on the window function or Chebyshev approximation, and therefore if these are not set properly, it is not possible to obtain a satisfactory frequency characteristic. However, it is generally difficult to set a window function or approximate expression appropriately. That is, the above described conventional filter design method requires a skilled technician to design the filter at much expense in time and effort and has a problem that it is not possible to design an FIR filter with a desired characteristic easily.

Furthermore, even if it is possible to design an FIR filter having substantially a desired characteristic, the number of taps of the designed filter becomes enormous and the coefficient values become extremely complicated and random values. For this reason, there is a problem that a large-scale circuit structure (adders, multipliers) is required to realize such a number of taps and coefficient values. Furthermore, there is also a problem that when the designed FIR filter is actually used, the amount of calculation becomes very large and processing load becomes heavy.

The present invention has been implemented to solve such a problem and it is an object of the present invention to make it possible to easily design an FIR digital filter having a desired frequency characteristic.

Furthermore, it is another object of the present invention to provide an FIR digital filter capable of realizing a desired frequency characteristic with a small circuit scale and with a high degree of accuracy.

### [Summary of the Invention]

The digital filter design method according to the present invention is characterized by carrying out a filter design using a basic filter formed by cascade connecting first and second unit filters so that the numerical sequence as a whole is symmetric . The first and second unit filters have asymmetric filter coefficients of numerical sequences whose values are set in such a way that the total values of the respective numerical sequences are non-zeros and the total values of every other values of the numerical sequences match and have the same signs.

Another mode of the present invention is characterized by carrying out a filter design using a basic filter formed by cascade connecting first and second unit filters so that the numerical sequence as a whole is symmetric. The first and second unit filters have asymmetric filter coefficients of numerical sequences whose values are set in such a way that the total values of the respective numerical sequences are zeros and the total values of every other values of the numerical sequences match and have the opposite signs.

A further mode of the present invention is characterized in that a pass frequency band of a filter is adjusted by inserting a delay of n clocks between taps corresponding to the asymmetric filter coefficients making up the first and second unit filters.

The digital filter according to the present invention comprises a tapped delay line made up of a plurality of delayers, characterized in that signals of the respective taps are multiplied several-fold according to the filter coefficients calculated using the filter design method according to any one of claims 1 to8, then added up the results of multiplication and output the addition result.

As described above, the present invention designs a digital filter by constructing a basic filter by cascade connecting two unit filters having predetermined asymmetric numerical sequences as filter coefficients and then cascade connecting a plurality of such basic filters, and can thereby automatically obtain a desired digital filter coefficients only by connecting the basic filters in series and allow even a non-expert technician to design a filter extremely simply.

Furthermore, according to the present invention, the above described predetermined asymmetric numerical sequences are obtained by dividing a predetermined symmetric numerical sequence at the center into two parts and therefore requires only an extremely small number of taps necessary for the digital filter designed and requires only a small number of types of filter coefficients necessary for each tap output. Moreover, this eliminates use of a window function and prevents generation of a discretization error in the filter coefficients obtained. Therefore, it is possible to drastically reduce the number of circuit elements (multipliers in particular), reduce the circuit scale, reduce power consumption and alleviate the calculation load, etc., and realize a desired frequency characteristic of the digital filter at a high degree of accuracy. Furthermore, since the digital filter designed has an extremely simple structure made up of a repetition of the same pattern of a basic filter, it is possible to reduce man-hours for integration and facilitate the integration into an IC.

### [Brief Description of the Drawings]

FIG. 1A and 1B are diagrams showing the circuit structure and numerical sequences of filter coefficients of 5-tap unit filters L10, H10;
FIG. 2 A and 2B are diagrams showing the filter coefficient generation algorithms of the 5-tap unit filters L10, H10;
FIG. 3A and 3B are diagrams explaining the meanings of filter coefficients of the 5-tap low-pass unit filter L10;
FIG. 4A and 4B are diagrams explaining the meanings of filter coefficients of the 5-tap high-pass unit filter H10;
FIG. 5 is a diagram showing the filter coefficient generation algorithm of a 5-tap low-pass unit filter L11;
FIG. 6 is a diagram showing the frequency-gain characteristic of the 5-tap low-pass unit filters L10, L11;
FIG. 7 is a diagram showing the filter coefficient generation algorithm of a 5-tap high-pass unit filter H11;
FIG. 8 is a diagram showing the frequency-gain characteristic of the 5-tap high-pass unit filters H10, H11;
FIG. 9 is a diagram showing the frequency-gain characteristic of a 5-tap low-pass unit filter (L10)^{m};
FIG. 10 is a diagram showing the frequency-gain characteristic of a 5-tap high-pass unit filter (H10)^{m};
FIG. 11A and 11B are diagrams explaining the extractions of frequency bands;
FIG. 12A, 12B and 12C are diagrams showing other examples of extractions of frequency bands;
FIG. 13A and 13B are diagrams showing the circuit structure and numerical sequences of filter coefficients of two types of 3-tap unit filter which is most fundamental in the filter design method according to a first embodiment;
FIG. 14 is a diagram showing the frequency characteristic of a 3-tap high-pass unit filter H10' when a simple numerical sequence {8, -9, 0, 1}/16 is used as filter coefficients;
FIG. 15 is a diagram showing the frequency characteristic of a 3-tap high-pass unit filter H10' when only a filter coefficient H3 is adjusted;
FIG. 16A and 16B are diagrams showing the frequency characteristic of the 3-tap high-pass unit filter H10' when filter coefficients H2, H3 are adjusted;
FIG. 17A and 17B are diagrams showing the circuit structure and numerical sequences of filter coefficients of unit filters L10", H10" according to this embodiment;
FIG. 18 is a diagram showing the frequency characteristic of the low-pass unit filter L10" according to this;
FIG. 19 is a diagram showing the frequency characteristic of the high-pass unit filter H10" according to this embodiment;
Fig. 20A and 20B are diagrams showing the frequency characteristic of a low-pass filter designed based on the first embodiment;
Fig. 21A and 21B are diagrams showing the frequency characteristic of a band pass filter designed based on the first embodiment;
Fig. 22A and 22B are diagrams showing the low-pass filter according to a second embodiment;
Fig. 23A and 23B are diagrams showing the frequency characteristic of a low-pass filter designed based on the second embodiment; and
FIG. 24A and 24B are diagrams showing the filter coefficient generation algorithms of 5-tap unit secondary filters L20, H20.

### [Detailed Description of the Preferred Embodiments]

With reference now to the attached drawings, embodiments of the present invention will be explained below.

The digital filter of this embodiment is an FIR filter of such a type that includes tapped delay lines made up of a plurality of delayers, multiplies output signals of the respective taps several-fold according to given filter coefficients and then adds up the results of multiplication and outputs the addition result.

### (First embodiment)

The filter design method according to a first embodiment is designed to create unit filters L1n" , H1n" (basic filters of the present invention) which will be described below, and allow an FIR filter having a desired frequency characteristic to be designed using only one of them. The suffix "n" to each numeral indicating the unit filter denotes the number of clocks of a delay to be inserted between taps, that is, the number of "0"s to be inserted between filter coefficients (which will be explained in detail later).

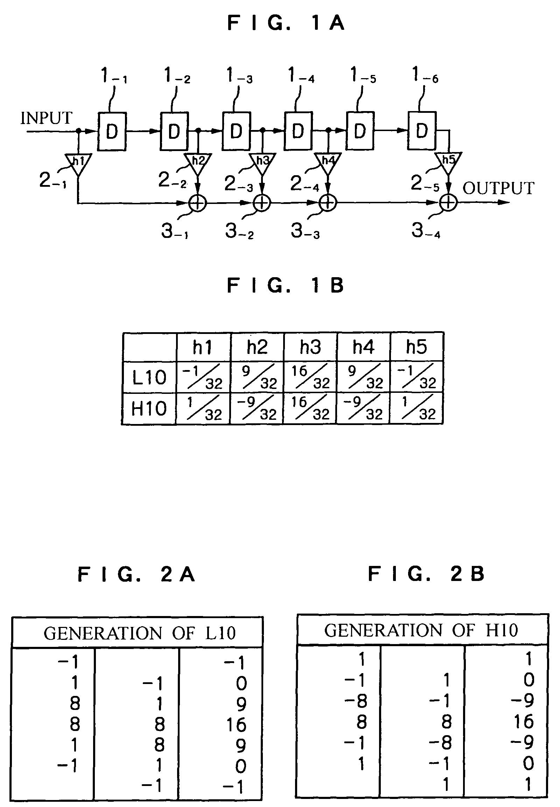

First, two types of 5-tap unit filters L1n, H1n which serve as a reference in understanding the above described unit filters L1n", H1n" will be explained. FIG. 1A and 1B are diagrams showing the 5-tap unit filters L10, H10. FIG. 1A shows the circuit structure and FIG. 1B Bshows numerical sequences of filter coefficients.

As shown in FIG. 1A, the 5-tap unit filters L10, H10 delay an input signal sequentially by 1 clock CK at a time using six cascade connected D-type flip flops 1₋₁ to 1₋₆. Then, the signals extracted from the predetermined taps of the respective D-type flip flops 1₋₁ to 1₋₆ are multiplied by filter coefficients h1 to h5 shown in FIG. 1B at five coefficient multipliers 2₋₁ to 2₋₅ respectively and all the multiplication results are added up using four adders 3₋₁ to 3₋₄ and output.

Both of the two types of 5-tap unit filters L10, H10 have the circuit structure shown in FIG. 1A and only the filter coefficients (multiplier values h1 to h5 of coefficient multipliers 2₋₁ to 2₋₅) are different as shown in FIG. 1B.

As is evident from FIG. 1B, the filter coefficients of the 5-tap low-pass unit filter L10 consist of an extremely simple numerical sequence {-1, 0, 9, 16, 9, 0 , -1}/32 (however, the parts corresponding to values "0" have no tap output as shown in FIG. 1A and are not used as filter coefficients). Such filter coefficients have a symmetric numerical sequence and have such a nature that the total value of the numerical sequence is non- zero and the total values of every other values of the numerical sequences match and have the same sign (-1+9+9-1=16, 0+16+0=16).

On the other hand, the filter coefficients of the 5-tap high-pass unit filter H10 consist of an extremely simple numerical sequence {1 , 0, -9, 16, -9, 0, 1}/32 (however, the parts corresponding to values "0" has no tap output and are not used as filter coefficients). Such filter coefficients have a symmetric numerical sequence and have such a nature that the total value of the numerical sequence is zero and the total values of every other values of the numerical sequences match and have the opposite signs (1-9-9+1=-16, 0+16+0=16).

Here, the meanings of the numerical sequences making up these filter coefficients will be explained using FIGS. 2 to 4.

FIG. 2A and 2B are diagrams showing the method of generating numerical sequences making up filter coefficients of the 5-tap unit filters L10, H10. As shown in FIG. 2A, the numerical sequence making up the filter coefficients of the 5-tap low-pass unit filter L10 is obtained by calculating a moving average of a predetermined digital basic function whose data value changes as {-1, 1 , 8 , 8 , 1, -1}/16 every one clock CK.

Furthermore, as shown in FIG. 2B, the numerical sequence making up the filter coefficients of the 5-tap high-pass unit filter H10 is obtained by calculating a moving average of a digital basic function whose data value changes as {1, -1, -8, 8, -1, 1}/16 every one clock CK and another digital basic function whose data value changes as {1, -1, 8, -8, -1, 1}/16 every one clock CK.

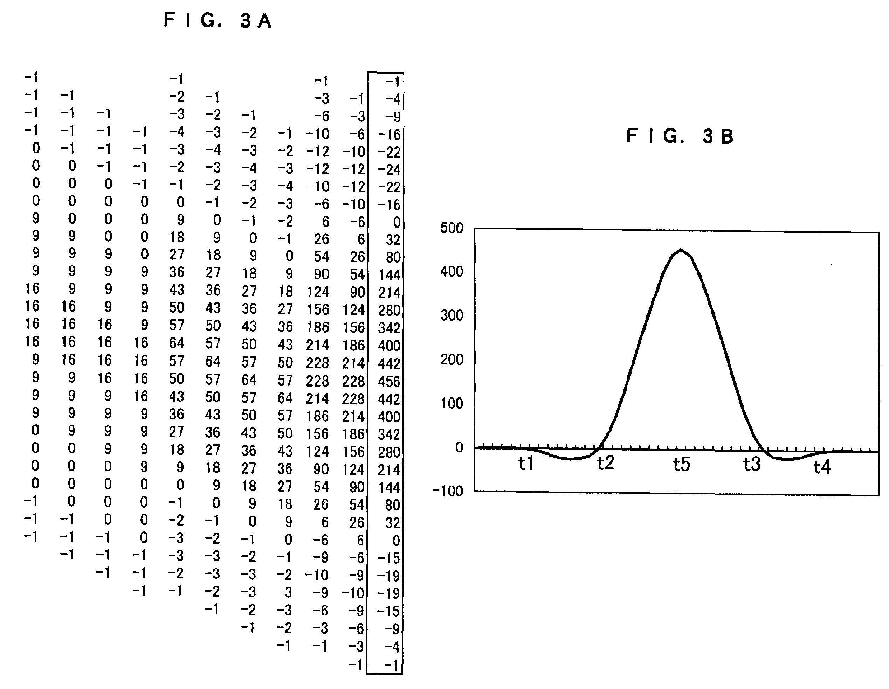

FIG. 3A and 3B are diagrams explaining the result obtained by applying a quadruple oversampling and convolution calculation on the numerical sequence making up the filter coefficients of the 5-tap low-pass unit filter L10. Here, for simplicity of explanation, an example of applying an oversampling and convolution calculation to an integer numerical sequence {-1 , 0, 9, 16, 9, 0 , -1} which is the original numerical sequence multiplied 32-fold is shown.

In FIG. 3A, a series of numerical sequences shown on the leftmost column is a value resulting from applying a quadruple oversampling to the original numerical sequence {-1, 0, 9, 16, 9, 0, -1}. Furthermore, the numerical sequences corresponding to the four columns from the leftmost column toward the right are obtained by shifting the numerical sequence shown on the leftmost column downward one by one. The column direction in FIG. 3A indicates the time axis and shifting the numerical sequence downward corresponds to gradually delaying the numerical sequence shown on the leftmost column.

That is, the numerical sequence on the second column from the left indicates the numerical sequence obtained by shifting the numerical sequence shown on the leftmost column by a 1/4 phase of a quadruple frequency clock 4CK. Furthermore, the numerical sequence shown on the third column from the left indicates the numerical sequence obtained by shifting the numerical sequence shown on the second column from the left by a 1/4 phase of a quadruple frequency clock 4CK and the numerical sequence shown on the fourth column from the left indicates the numerical sequence obtained by shifting the numerical sequence shown on the third column from the left by a 1/4 phase of a quadruple frequency clock 4CK.

Furthermore, the numerical sequence on the fifth column from the left corresponds to values obtained by adding up the respective numerical sequences on the first to fourth columns among the corresponding rows. Through the processing up to the fifth column from the left, quadruple oversampling involving a four-phase convolution calculation is executed in a digital form.

The numerical sequences corresponding to the four columns from the fifth column toward the right are obtained by shifting the numerical sequence shown on the fifth column downward one by one. Furthermore, the numerical sequence on the ninth column from the left corresponds to values obtained by adding up the respective numerical sequences on the fifth to eighth columns among the corresponding rows. Through this processing up to the ninth column from the left, quadruple oversampling involving a four-phase convolution calculation is executed twice in a digital form.

Furthermore, the numerical sequence on the tenth column from the left is obtained by shifting the numerical sequence shown on the ninth column downward by one. Furthermore, the numerical sequence on the 11th column from the left (rightmost column) corresponds to values obtained by adding up the respective numerical sequences on the ninth column and tenth column among the corresponding rows.

FIG. 3B shows in a graph the numerical sequence finally obtained on the rightmost column in FIG. 3A. The function having the waveform shown in this FIG. 3B has finite values other than "0" only when the sample position along the horizontal axis exists between t1 and t4 and all values in other areas are "0" , that is, the function whose values converge to "0" at sample positions t1, t4. The case where values of a function take finite values other than "0" in local regions and take "0" in other regions is called "finite base".

Furthermore, the function shown in this FIG. 3B is a sampling function characterized in that a maximum value is taken only at the central sample position t5 and values are 0 at four sample positions of t1, t2, t3, t4 and the function passes through all sample points necessary to obtain smooth waveform data.

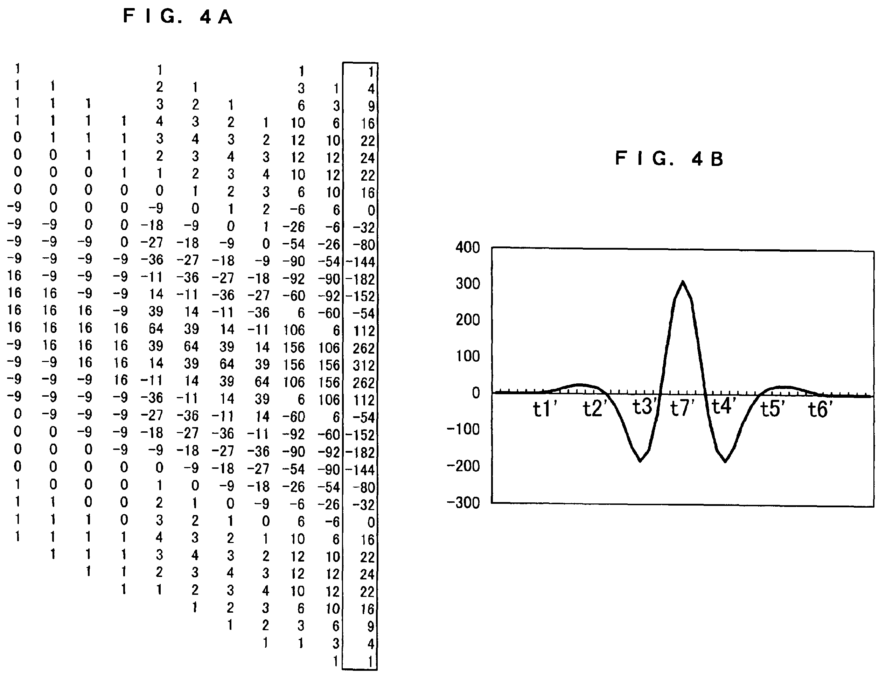

Next, FIG. 4A and 4B are diagrams explaining the result of applying quadruple oversampling and convolution calculation to a numerical sequence making up filter coefficients of the 5-tap high-pass unit filter H10. Here, for clarity of explanation, an example is also shown in which an oversampling and convolution calculation are applied to an integer numerical sequence {1, 0 , -9 , 16 , -9 , 0 , 1} obtained by multiplying the original numerical sequence 32-fold.

FIG. 4A shows a calculation process similar to that in FIG. 3A. The numerical sequence on the finally obtained rightmost column shown in this FIG. 4A is expressed in a graph shown in FIG. 4B. The function shown in this FIG. 4B is also a sampling function which takes a maximum value only at a central sample position t7' and is differentiable over the entire region one time and is a function of a finite base which converges to 0 at sample positions t1', t6'.

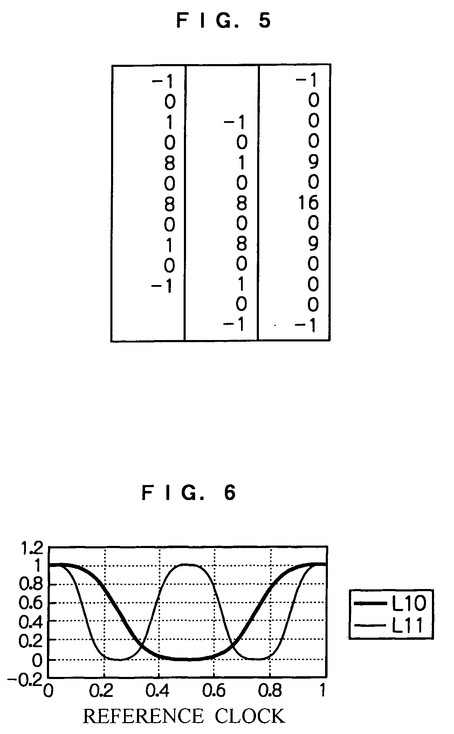

Next, the case where the number of clocks n of delays inserted between taps is assumed to be n≥1 will be explained. FIG. 5 is a diagram showing the filter coefficients of a 5-tap low-pass unit filter L11 (when n=1). As shown in this FIG. 5, filter coefficients of a 5-tap low-pass unit filter L11 are generated by inserting one "0" between filter coefficients of the above described 5-tap low-pass unit filter L10.

Likewise, filter coefficients of a 5-tap low-pass unit filter L1n (n=2 , 3 ,···) are generated by inserting n "0"s between filter coefficients of the 5-tap low-pass unit filter L10.

FIG. 6 is a diagram showing the frequency-gain characteristics as a result of carrying out an FFT (Fast Fourier Transform) on the numerical sequences of the 5-tap low-pass unit filters L10, L11. Here, the gain and frequency are normalized by "1".

As is evident from this FIG. 6, the 5-tap low-pass unit filters L10, L11 have a gain of 0.5 at a central frequency and can provide good low-pass filter characteristics free of any overshoot in a low frequency region or ringing in a high frequency region. Furthermore, if the number of "0"s to be inserted between the filter coefficients is n, the frequency axis (period with respect to the frequency direction) of the frequency-gain characteristic is 1/n.

The numerical sequence in above FIG. 2A which is the basis for realizing such a low-pass filter characteristic also becomes the basis of the sampling function of the finite base shown in FIG. 3B. While a sampling function which is conventionally generally used converges to "0" at a sample position of t=±∞, the sampling function shown in FIG. 3B converges to "0" at finite sample positions of t=t1, t4.

For this reason, when the numerical sequence in FIG. 2A is FFT-transformed, only the data corresponding to the range from t=t1 to t4 is meaningful. This is not the case where the data corresponding to a region outside the range from t=t1 to t4 which should be originally taken into consideration is ignored, but the data need not be theoretically considered, and therefore no discretization error occurs. Therefore, using the numerical sequence shown in FIG. 2A as the filter coefficients eliminates the necessity for discretizing coefficients using a window function and can obtain a good low-pass filter characteristic.

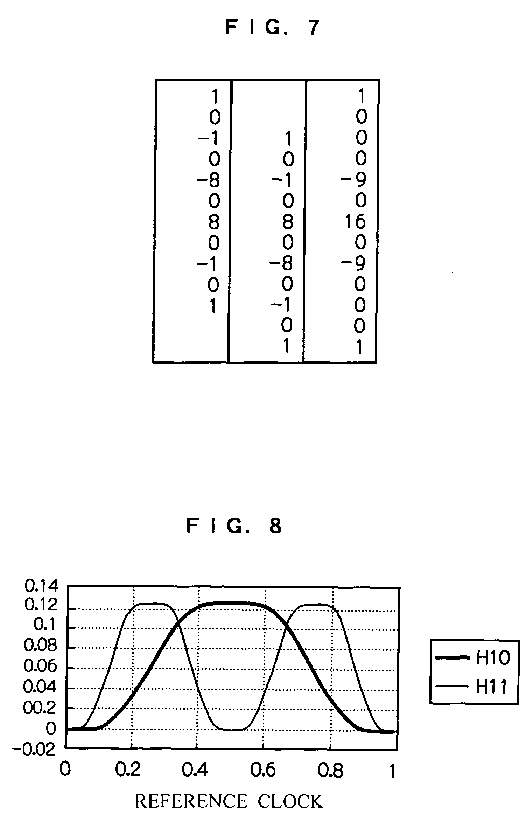

FIG. 7 is a diagram showing the filter coefficients of a 5-tap high-pass unit filter H11. As shown in this FIG. 7, the filter coefficients of the 5-tap high-pass unit filter H11 are generated by inserting one "0" between the filter coefficients of the 5-tap high-pass unit filter H10.

Likewise, filter coefficients of a 5-tap high-pass unit filter H1n (n=2, 3, ···) are generated by inserting n "0"s between the filter coefficients of the 5-tap high-pass unit filter H10.

FIG. 8 is a diagram showing the frequency-gain characteristics of the 5-tap high-pass unit filters H10, H11. Here, the gain and frequency are also normalized by "1". As is evident from this FIG. 8, the gain is 0.5 at the central frequency of the 5-tap high-pass unit filters H10, H11 and it is possible to obtain a good high-pass filter characteristic free of any overshoot in a high frequency region or ringing in a low frequency region. Furthermore, if the number of "0"s to be inserted between the filter coefficients is n, the frequency axis (period with respect to the frequency direction) of the frequency-gain characteristic is 1/n.

The numerical sequence in above FIG. 2B which is the basis for realizing such a high-pass filter characteristic also becomes the basis of the sampling function of the finite base as shown in FIG. 4B. Therefore, using this numerical sequence as the filter coefficient eliminates the necessity for discretizing coefficients using a window function, and can thereby obtain a good high-pass filter characteristic.

Next, a cascade arrangement (connection in series) of 5-tap unit filters will be explained. A cascade arrangement of 5-tap unit filters causes coefficients of the respective unit filters to be multiplied and added up among themselves and new filter coefficients are thereby created. In the explanations below, when the number of cascade arrangement of 5-tap low-pass unit filters L10 is m, suppose this is described as (L10)^{m}.

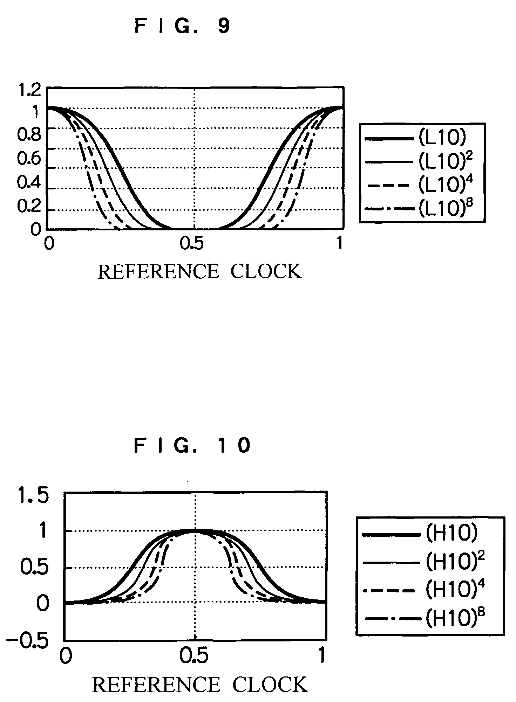

FIG. 9 is a diagram showing the frequency-gain characteristics of 5-tap low-pass unit filters L10, (L10)², (L10)⁴ and (L10)⁸. In this FIG. 9, the gain and frequency are also normalized by "1". When there is only one 5-tap low-pass unit filter L10, the clock at a position where the amplitude is 0.5 is 0.25. On the contrary, when the number of cascade arrangement m increases, the pass band width of the filter decreases. For example, when m=8, the clock at which the amplitude is 0.5 is 0.125.

FIG. 10 is a diagram showing the frequency-gain characteristics of 5-tap high-pass unit filters H10, (H10)², (H10)⁴ and (H10)⁸. In this FIG. 10, the gain and frequency are also normalized by "1". When there is only one 5-tap high-pass unit filter H10, the clock at a position where the amplitude is 0.5 is 0.25. On the contrary, when the number of cascade arrangement m increases, the pass band width of the filter decreases. For example, when m=8, the clock at which the amplitude is 0.5 is 0.375.

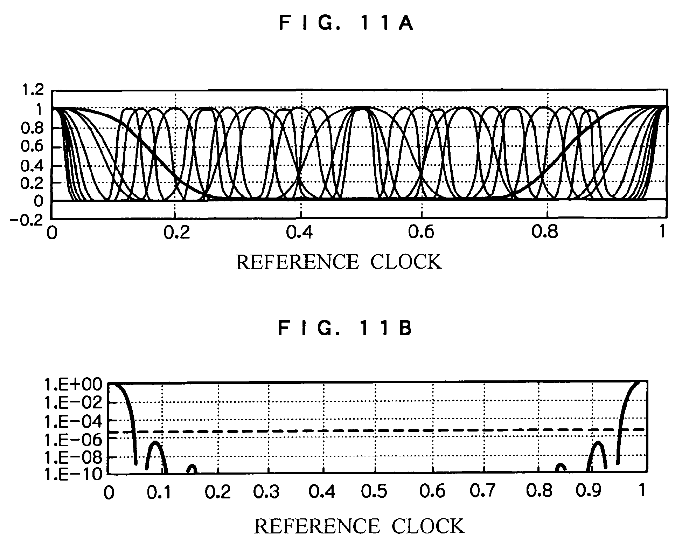

Next, extractions of desired frequency bands will be explained. FIG. 11A and 11B are diagrams explaining the extractions of frequency bands. Frequency bands are extracted using four or more above described cascade arranged unit filters. FIG. 11A shows frequency-gain characteristics of 5-tap low-pass unit filters (L10)⁴, (L11)⁴, (L13)⁴ and (L17)⁴ together in one graph. In this FIG. 11A, the gain and frequency are also normalized by "1".

Combining these plurality of types of 5-tap low-pass unit filters (L10)⁴, (L11)⁴, (L13)⁴ and (L17)⁴ causes the respective characteristic values to cancel out each other and extracts frequency bands. Furthermore, by combining these waveforms as the basis and moving them in the axial direction of inversion frequency if necessary, it is possible to create a filter whose pass band consists of only a desired frequency band.

FIG. 11B shows frequency characteristics obtained when these four types of 5-tap low-pass unit filters (L10)⁴, (L11)⁴, (L13)⁴, (L17)⁴ are cascade connected. According to this, it is possible to obtain a low-pass filter having a good attenuation characteristic whose pass band consists of an extremely narrow low frequency region. There is slight ringing, but this ringing occurs in regions of drops by -106 dB or more, and therefore the ringing can be substantially ignored.

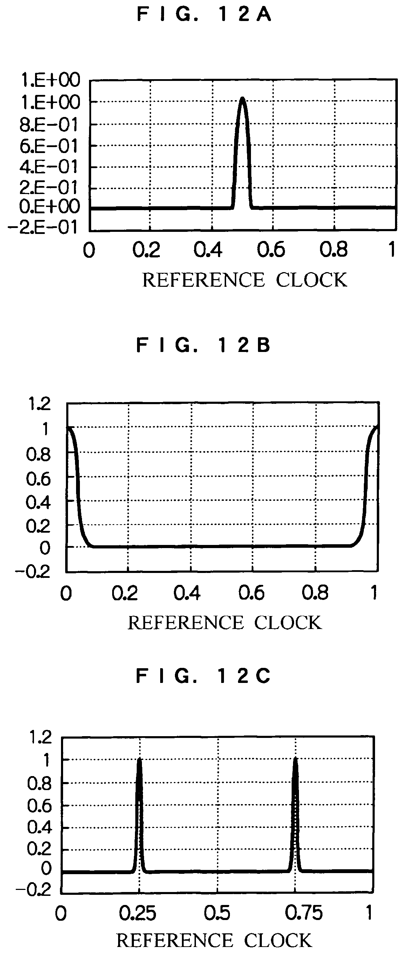

FIG. 12A to 12C are diagrams showing other examples of extractions of frequency bands. As shown in FIG. 12A, by combining 5-tap high-pass unit filter (H10)⁸ and 5-tap low-pass unit filters (L11)⁸, (L13)⁸ and (L17)⁸ and cascade connecting them, it is possible to obtain a high-pass filter whose pass band consists of a predetermined frequency band.

Furthermore, as shown in FIG. 12B, by combining 5-tap low-pass unit filters (L10)⁴, (L11)⁸ and (L13)⁴ and cascade connecting them, it is possible to obtain a low-pass filter whose pass band consists of a predetermined frequency band. Furthermore, as shown in FIG. 12C, by combining the 5-tap high-pass unit filter (H11)⁸ and 5-tap low-pass unit filters (L13)⁴, (L17)⁴ and (L115)⁸ and cascade connecting them, it is possible to obtain a band pass filter whose pass band consists of a predetermined frequency band.

As shown above, using a 5-tap unit filter having a predetermined basic numerical sequence as filter coefficients and by arbitrarily combining them, it is possible to automatically generate filter coefficients of an FIR filter having a desired frequency characteristic by only combining unit filters. Therefore, the filter design method is simple and easily understandable and allows even a non-expert technician to design a filter extremely simply.

Furthermore, only an extremely small number of taps are required for the filter circuit designed by applying the above described technique and only a small number of types of filter coefficients are required for each tap output, and it is thereby possible to considerably simplify the structure of the calculation section of the filter circuit. Therefore, it is possible to drastically reduce the number of circuit elements (multipliers in particular), reduce the filter circuit scale, reduce power consumption and alleviate the calculation load, etc.

Furthermore, since the filter circuit designed by applying the above described technique has an extremely simple structure made up of a repetition of almost the same pattern, this filter circuit has a merit that it is possible to reduce man-hours for integration and facilitate the integration into an IC. Furthermore, in the characteristic aspect, it is possible to make quite a large improvement to the cutoff characteristic and also obtain a phase characteristic with a linear and excellent filter characteristic.

The contents described so far have already been applied for a patent by the present applicant (Japanese Patent Application No. 2001-321321). This embodiment has further improved the contents of this application already filed and is intended to allow an FIR filter having a desired frequency characteristic to be designed by only connecting one type of unit filters L1n" or H1n" as described above.

First, 3-tap unit filters L1n' , H1n' which are components of the above described unit filters L1n", H1n" will be described. The filter coefficients of these 3-tap unit filters L1n', H1n' are obtained by dividing the numerical sequence of filter coefficients of the above described 5-tap unit filters L1n, H1n at the center into two parts and then further adjusting one of them.

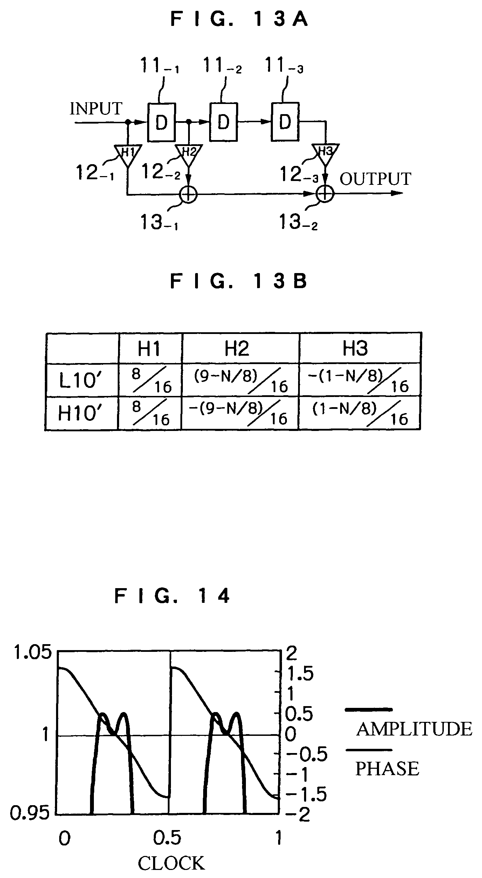

FIG. 13A and 13B are diagrams showing the 3-tap unit filters L10' , H10' , FIG. 13A shows the circuit structure and FIG. 13B shows their numerical sequences of filter coefficients. As shown in FIG. 13A, the 3-tap unit filters L10' , H10' delay an input signal sequentially by 1 clock CK at a time using three cascade connected D-type flip flops 11₋₁ to 11₋₃. Then, the signals extracted from the predetermined taps of the respective D-type flip flops 11₋₁ to 11₋₃ are multiplied by filter coefficients H1 to H3 shown in FIG. 13B at three coefficient multipliers 12₋₁ to 12₋₃ respectively and all the multiplication results are added up using two adders 13₋₁ and 13₋₂ and output the addition result.

Both of the two types of 3-tap unit filters L10', H10' have the circuit structure shown in FIG. 13A and only the filter coefficients (multiplier values H1 to H3 of coefficient multipliers 12₋₁ to 12₋₃) are different as shown in FIG. 13B.

The filter coefficients of the 3-tap low-pass unit filter L10' have an asymmetric numerical sequence and have such a nature that the total value of the numerical sequence is non-zero and the total values of every other values of the numerical sequences match and have the same sign. Furthermore, the filter coefficients of the 3-tap high-pass unit filter H10' have an asymmetric numerical sequence and have such a nature that the total value of the numerical sequence is zero and the total values of every other values of the numerical sequences match and have the opposite signs.

Thus, the filter coefficients of these 3-tap unit filters L10' , H10' have the same nature as the above described 5-tap unit filters L10, H10 except that they are of an asymmetric type. However, they have relatively more complicated values than the filter coefficients of the 5-tap unit filters L10, H10. The reasons for this will be explained below.

FIG. 14 is a diagram showing the frequency characteristics when filter coefficients {1, 0, -9, 16, -9, 0, 1}/32 of the 5-tap high-pass unit filter H10 are divided into two parts at the center and a simple numerical sequence {8 , -9 , 0, 1}/16 corresponding to one of them is used as filter coefficients (however, the parts whose value is "0" have no tap output and are not used as filter coefficients). Here, the gain and frequency are normalized by "1".

As shown in this FIG. 14, if one of two parts into which the numerical sequence of the 5-tap high-pass unit filter H10 is simply divided is used as filter coefficients, peaks of the parts which become pass bands in the frequency characteristic undulate and produce maximum values and those maximum values exceed "1". A unit filter having such a frequency characteristic is not suitable for a system which designs a desired FIR filter by cascade connecting these unit filters.

Therefore, the above described simple numerical sequence {8, -9, 0, 1}/16 is adjusted. First, the absolute value of the filter coefficient H3 which determines the frequency characteristic on the high frequency side is reduced. That is, the coefficient value is changed from "1" to "1-N/8" (any one of N=1, 2 ,···8) and the high frequency component is reduced so that only the center of the pass band becomes a maximum value of the gain.

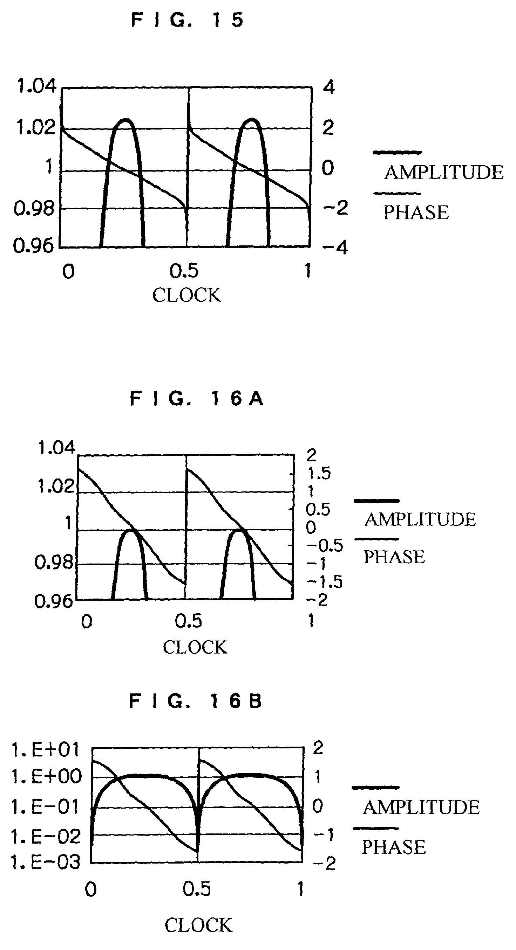

FIG. 15 is a diagram showing the frequency characteristic of the filter coefficient H3 when N=3. As is evident from this FIG. 15, the undulation of the pass band is improved and only the central part becomes a maximum value of the gain. However, the maximum value still exceeds "1". Thus, the coefficient value is further adjusted so that the maximum value of the gain just becomes "1".

The maximum value can be adjusted using the filter coefficient H2 whose sign is opposite to the sign of the filter coefficient H3 used to adjust the high frequency component. Here, the absolute value of the value of the filter coefficient H2 is reduced from "-9" to "-(9-N/8)" (any one of N=1, 2,···8).

At this time, the value of N for gain adjustment (value of N of filter coefficient H2) is matched with the above described value of N for high frequency adjustment so that the total value of the adjusted numerical sequence becomes the same as the total value of the numerical sequence before adjustment (before adjustment: 8-9+0+1=0, after adjustment: 8-(9-N/8)+0+(1-N/8)=0). Furthermore, the total value of every other values of the numerical sequence is also adjusted so that it does not change before and after adjustment.

FIG. 16A and 16B are diagrams showing the frequency characteristics of the filter coefficients H2, H3 when N=3, FIG. 16A indicates the gain on a linear scale and FIG. 16B indicates the gain on a logarithmic scale. In this FIG. 16, the gain and frequency are also normalized by "1".

As is evident from this FIG. 16, when the filter coefficients H2, H3 are adjusted, there is no undulation in the pass band and only the central part becomes the maximum value of the gain and the maximum value just becomes "1". Furthermore, there is also a satisfactory amount of attenuation of approximately -55 dB. The 3-tap high-pass unit filter H10' having such a frequency characteristic is suitable for a system which designs a desired FIR filter with these 3-tap high-pass unit filters H10' cascade connected.

Furthermore, by inserting n "0"s between the filter coefficients of the 3-tap high-pass unit filter H10' as in the case of the above described 5-tap high-pass unit filter H1n (n=1,2,···), it is possible to generate a 3-tap high-pass unit filter H1n'.

In the same way as for the above described 3-tap high-pass unit filter H10', it is also possible to adjust filter coefficients of the 3-tap low-pass unit filter L10' as appropriate. That is, as opposed to a numerical sequence {8, 9, 0, -1}/16 obtained by simply dividing the numerical sequence of the 5-tap low-pass unit filter L10 into two parts, the absolute value of the value of the filter coefficient H3 which determines the frequency characteristic on the high frequency side is reduced from "-1" to "-(1-N/8)".

Furthermore, the maximum value of the gain is adjusted using the filter coefficient H2 having a sign opposite to the sign of this filter coefficient H3. That is, the value of the filter coefficient H2 is reduced from "9" to "9-N/8". At this time, the value of N for high frequency adjustment is matched with the value of N for gain adjustment so that the total value of the adjusted numerical sequence becomes equal to the total value of the numerical sequence before adjustment (before adjustment: 8+9+0-1=16, after adjustment: 8+(9-N/8)+0-(1-N/8)=16). Furthermore, it is also adjusted so that the total value of every other values of the numerical sequence remains unchanged before and after adjustment.

Thus, even when the filter coefficient values of the 3-tap low-pass unit filter L10' are adjusted, it is possible to obtain a low-pass filter characteristic so that there is no undulation in the pass band and only the central part becomes a maximum value of the gain and the maximum value just becomes "1". The 3-tap low-pass unit filter L10' having such a frequency characteristic is also suitable for a system which designs a desired FIR filter by cascade connecting these 3-tap low-pass unit filters L10'.

Furthermore, in the same way as for the above described 5-tap low-pass unit filter L1n (n=1,2,···), by inserting n "0"s between the filter coefficients of the 3-tap low-pass unit filter L10', it is possible to generate a 3-tap low-pass unit filter L1n'.

Here, the filter coefficients of the 3-tap unit filters L10', H10' may also be generated by adjusting a numerical sequence {-1, 0, 9, 8}/16, {1, 0, -9, 8}/16 which is one of two parts into which the numerical sequence of the filter coefficients of the 5-tap unit filter L10, H10 is divided at the center.

As described so far, it is also possible to design an FIR filter having a desired frequency characteristic by cascade connecting the 3-tap unit filters L1n' or H1n' as they are. However, since these filter coefficients are both asymmetric, their phase linearity is not guaranteed. Therefore, this embodiment further makes adjustments so as to realize a linear phase characteristic while using the 3-tap unit filters L1n' , H1n' which can reduce the number of taps.

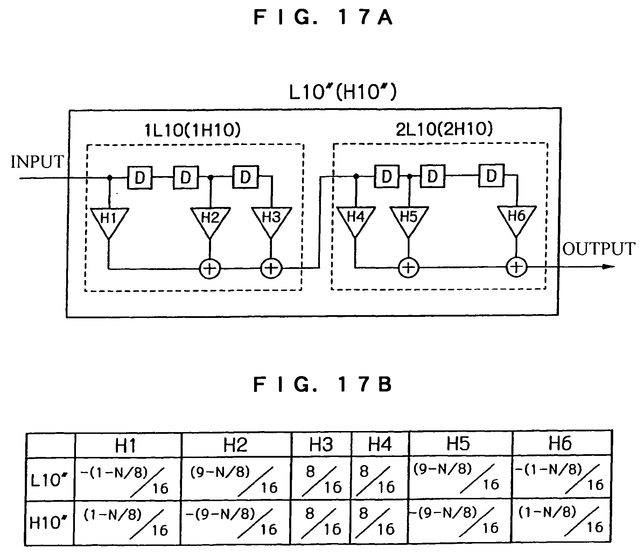

FIG. 17A and 17B are diagrams showing the unit filter L10", H10" according to this embodiment, FIG. 17A shows the circuit structure and FIG. 17B shows numerical sequences of filter coefficients.

As shown in FIG. 17A, both the unit filters L10", H10" of this embodiment have similar structures. That is, the low-pass unit filter L10" is constructed of two 3-tap low-pass unit filters 1L10, 2L10 cascade connected. Furthermore, the high-pass unit filter H10" is constructed of two 3-tap high-pass unit filters 1H10, 2H10 cascade connected.

As shown in FIG. 17B, the 3-tap low-pass unit filter 2L10 which is one component of the low-pass unit filter L10" uses filter coefficients H4 to H6 obtained by dividing the numerical sequence {-1, 0, 9, 16, 9, 0, -1}/32 of the above described 5-tap low-pass unit filter L10 into two parts and further adjusting the numerical sequence (8, 9, 0, -1)/16 which is one of them. This is the same as the 3-tap low-pass unit filter L10' explained above. Furthermore, the other 3-tap low-pass unit filter 1L10 uses filter coefficients H1 to H3 obtained by further adjusting the numerical sequence {-1, 0, 9, 8}/16 which is the other part of the above described numerical sequence divided into two parts.

Furthermore, the 3-tap high-pass unit filter 2H10 which is one component of the high-pass unit filter H10" uses filter coefficients H4 to H6 obtained by dividing the numerical sequence {1, 0, -9, 16, -9, 0, 1}/32 of the filter coefficients of the above described 5-tap high-pass unit filter H10 into two parts and further adjusting the numerical sequence {8, -9, 0, 1}/16 which is one of them. This is the same as the 3-tap high-pass unit filter H10' explained above. Furthermore, the other 3-tap high-pass unit filter 1H10 uses filter coefficients H1 to H3 obtained by further adjusting the numerical sequence {1, 0 , -9, 8}/16 which is the other part of the numerical sequence divided into two parts.

The connection relationship between the above described two 3-tap low-pass unit filters 1L10, 2L10 and the connection relationship between the above described two 3-tap high-pass unit filters 1H10 , 2H10 may also be right-and-left opposite to that shown in FIG. 17A.

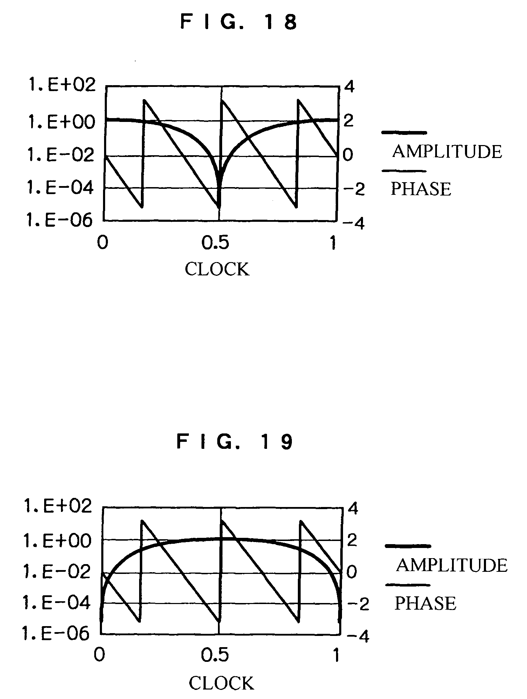

When the unit filters L10" , H10" are constructed as shown above, the filter coefficients become symmetric and therefore the phase characteristic becomes linear. FIG. 18 is a diagram showing the frequency characteristic of the low-pass unit filter L10" and FIG. 19 is a diagram showing the frequency characteristic of the high-pass unit filter H10" and express the gain on a logarithmic scale. In these FIG. 18 and FIG. 19, the gain and frequency are also normalized by "1".

As is evident from these figures, there is no undulation in the pass band in the frequency-gain characteristics and a maximum value is exactly set to "1" . Furthermore, an amount of attenuation obtained is as good as approximately -55 dB. Furthermore, the frequency-phase characteristic has an excellent linear phase characteristic. Therefore, by cascade connecting the unit filters L1n" , H1n" having such a frequency characteristic as described in the first embodiment, it is possible to construct a linear phase filter having symmetric coefficients with a very small number of taps.

Here, the unit filters L10", H10" shown in FIG. 17 are provided with 6 taps in total and have more taps than the 5-tap units L10, H10. However, while the 5-tap units L10, H10 are constructed of one stage, the unit filters L10", H10" are constructed of two 3-tap unit filters cascade connected. Therefore, the band width is already narrower than that of the 5-tap units L10, H10.

Therefore, this embodiment is particularly effective when an FIR filter having a narrower band width is designed. That is, it is possible to drastically reduce the number of cascade connected unit filters necessary to realize a desired narrow band width as a whole compared to the case where the 5-tap unit filters L10, H10 are used. This can reduce the circuit scale as a whole.

Next, a few design examples of the digital filter according to this embodiment will be explained. First, design examples of a low-pass filter using the low-pass unit filter L10" will be explained. Suppose the target specification of the low-pass filter to be designed is as follows. That is, a sampling frequency Fs of a signal is 48 KHz, band width of -3 dB is 3.5 KHz, band width of -80 dB is 8 KHz and attenuation amount of out-of-band is -80 dB or above.

For example, the low-pass filter realizing this target specification can be constructed by cascade connecting 64 low-pass unit filters L10" assuming N=2.6 (the structure in this case is expressed by {1L(2.6)10*2L(2.6)10}⁶⁴).

In order for the characteristic to meet the target specification, it is necessary to adjust the band width and inclination of a pass band. The band width can be narrowed by increasing the number of stages of unit filters connected in series. On the other hand, the inclination can be adjusted by changing the parameter value N. The standard for this parameter value N is 3; the inclination decreases when N>3 and the inclination increases when N<3. Here, assuming N=2.6 and the number of filters connected in series is 64, the characteristic of a low-pass filter which meets the above described target specification is obtained.

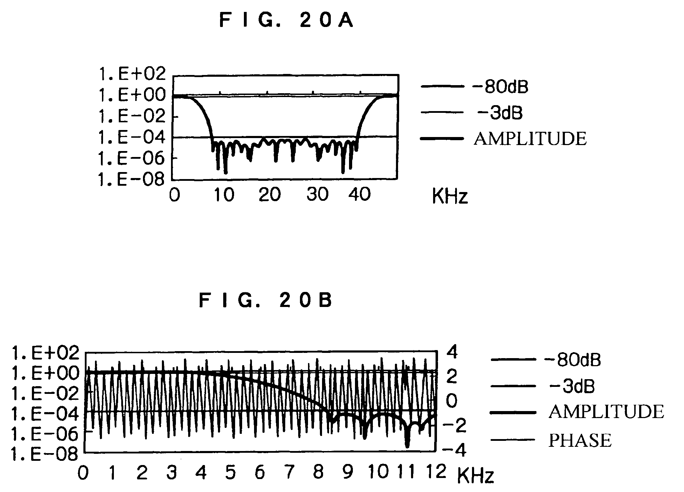

Fig. 20A and 20B are diagrams showing the frequency characteristic of the low-pass filter structured as above and shows the gain on a logarithmic scale. Fig. 20B is a partial enlarged view of the characteristic shown in Fig. 20A. As is evident from this Fig. 20, the low-pass filter {1L(2.6)10*2L(2.6)10}⁶⁴ satisfies the above described target specification. Furthermore, since the filter coefficients are symmetric, its phase characteristic is linear.

Furthermore, the number of D-type flip flops per bit necessary for the low-pass filter structured as above is 49 and the number of taps is 49, and there are only 23 types of filter coefficients (types of values calculated). When 64 unit filters L10" having 6 taps are connected in series, the number of D-type flip flops and the number of taps exceed 49. However, the filter coefficients of this low-pass filter are generated based on the above described functions of the finite base and coefficient values become as small as negligible near both sides of the cascade arrangement (series connection). From the nature of the finite base, no discretization error occurs even if this part is ignored, and therefore this part is excluded.

The excluded remaining part becomes final filter coefficients obtained for the low-pass filter that satisfies the target specification. Therefore, these filter coefficients need to be actually constructed as hardware and the number of D-type flip flops and taps required for this are only 49 . This can drastically reduce the number of D-type flip flops and the number of taps required as a whole and make the structure of the filter circuit extremely simple.

Next, a design example of a band pass filter using high-pass unit filters H11" will be explained. Suppose the target specification of the band pass filter to be designed is as follows. That is, a sampling frequency Fs of a signal is 1.8 MHz, band width of -3 dB is 100 KHz, band width of -80 dB is 200 KHz and attenuation amount of out-of-band is -80 dB or above.

For example, the band pass filter realizing this target specification can be constructed by cascade connecting 704 high-pass unit filters H11" assuming N=2.7.

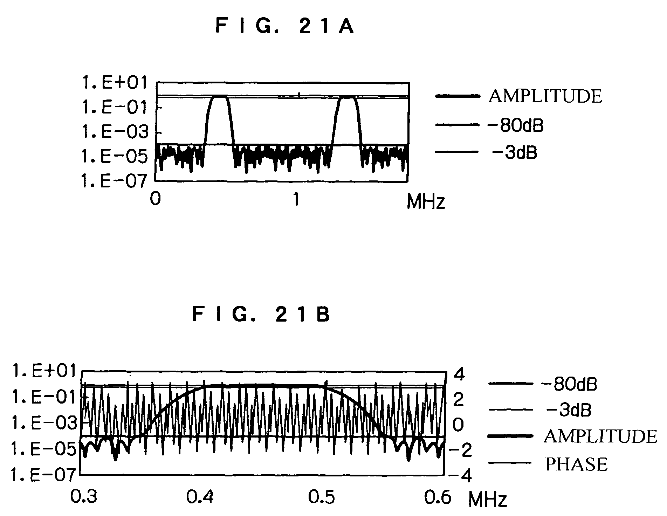

Fig. 21A and 21B are diagrams showing the frequency characteristic of the band pass filter structured as above and shows the gain on a logarithmic scale. Fig. 21B is a partial enlarged view of the characteristic shown in Fig. 21A. As is evident from this Fig. 21, the band pass filter {1H (2.7) 11*2H (2.7) 11}⁷⁰⁴ satisfies the above described target specification. Furthermore, its phase characteristic is also linear.

Furthermore, the number of taps per bit necessary for the band pass filter structured as above except parts whose coefficient values are as small as negligible is only 77 and there are only 31 types of filter coefficients. Furthermore, the number of D-type flip flops per bit is only 161 stages.

Though not shown here, it is also possible to construct a high-pass filter having a desired characteristic by connecting in series a plurality of high-pass unit filters H10".

Furthermore, Fig. 20 and Fig. 21 above show an example of a case where the number of processing bits is assumed to be 16, but increasing the number of processing bits makes it possible to obtain a characteristic having deeper attenuation. In other words, it is possible to obtain a digital filter whose amount of attenuation depends on the number of processing bits.

As described above in detail, according to this embodiment, by connecting in series one type of unit filters L1n" or H1n" having a predetermined basic numerical sequence as filter coefficients, it is possible to obtain filter coefficients of an FIR filter having a desired frequency characteristic through only this cascade arrangement. Therefore, the filter design method is quite simple and easily understandable and allows even a non-expert technician to design a filter extremely simply.

Furthermore, only an extremely small number of taps are required for the filter circuit designed by applying the above described technique and only a small number of types of filter coefficients are required for each tap output , and it is thereby possible to considerably simplify the structure of the calculation section of the filter circuit. Therefore, it is possible to drastically reduce the number of circuit elements and reduce the circuit scale of the filter circuit. Furthermore, since the filter circuit designed by applying the above described technique has an extremely simple structure made up of a repetition of completely the same pattern, this filter circuit also has a merit that it is possible to reduce man-hours for integration and facilitate the integration into an IC.

Here, about the 5-tap unit filters L1n, H1n which have already been applied for a patent, it is possible to design a digital filter having a desired characteristic through only one type of series connections. However, designing a digital filter with a narrow band width requires a much greater number of series connection stages than this embodiment and requires quite many a taps and D-type flip flops.

For this reason, it is not realistic to design a digital filter using only one type of 5-tap unit filters L1n, H1n and it is necessary to combine a plurality of types of unit filters and extract frequency bands. In contrast, this embodiment can realize a narrow band width with fewer series connection stages of unit filters L1n" or H1n" , and can thereby design a digital filter with series connections of only one type of unit filters L1n" or H1n".

### (Second embodiment)

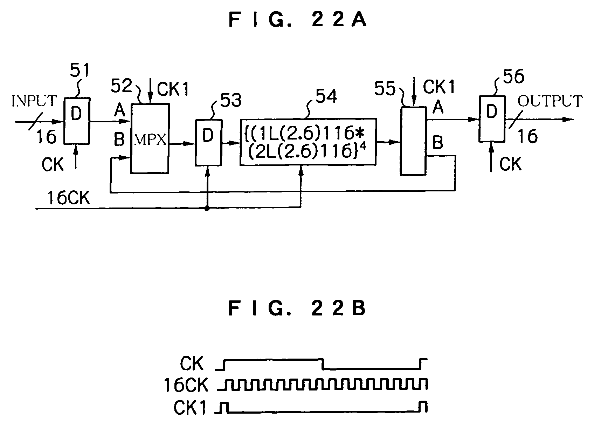

Next, a second embodiment of the present invention will be described. Fig. 22A and 22B are diagrams showing the above described low-pass filter {1L(2.6)10*2L(2.6)10}⁶⁴, Fig. 22A shows the circuit structure and Fig. 22B shows clocks to be used.

The low-pass filter shown in Fig. 22 is constructed of D-type flip flops 51, 56 operating on a reference clock CK, D-type flip flops 53 and 4-stage processing section 54 operating on a 16 times frequency clock 16CK, and a multiplexer 52 and data selector 55 operating on a 1/16 times frequency clock CK1. The 4-stage processing section 54 is constructed of a low-pass filter {1L(2.6)116*2L(2.6)116}⁴.

The data input to the D-type flip flop 51 which is the first stage is input to the terminal A side of the multiplexer 52. Data which is the result of low-pass filter processing output from the terminal B of the data selector 55 is input to the terminal B side of this multiplexer 52. The multiplexer 52 selectively outputs any one of the data input to these terminals A, B to the D-type flip flop 53 which is the next stage.

In this example, the terminal A side is selected at a timing at which clock CK1 is given to the multiplexer 52, the terminal B side is selected at any other timings and the selected data is output to the D-type flip flop 53. The D-type flip flop 53 stores the data supplied from the multiplexer 52 temporarily and outputs the data to the 4-stage processing section 54.

The 4-stage processing section 54 carries out low-pass filtering {1L(2.6)116*2L(2.6)116}⁴ on the data supplied from the D-type flip flop 53. The data output from this 4-stage processing section 54 is input to the data selector 55. The data selector 55 selectively outputs the data supplied from the 4-stage processing section 54 to either the D-type flip flop 56 or multiplexer 52.

That is, the data selector 55 selects the terminal A side at a timing at which the clock CK1 is given and outputs the data supplied from the 4-stage processing section 54 to the D-type flip flop 56. At other timings, the data selector 55 selects the terminal B side and outputs the data supplied from the 4-stage processing section 54 to the multiplexer 52.

By the above described structure, the data input through the D-type flip flop 51 is subjected to low-pass filter processing of {1L(2.6)116*2L(2.6)116}⁴ 16 times repeatedly at the 4-stage processing section 54 and the resultant data is output through the D-type flip flop 56. Thus, the same processing as that of {1L(2.6)10*2L(2.6)10}⁶⁴ is carried out on the input data.

The above described first embodiment can construct a digital filter by only connecting in series one type of unit filters and the digital filter is made up of a repetition of completely the same pattern. The second embodiment can further reduce the number of taps to be used by constructing the parts corresponding to the repetition of this same pattern using a loop circuit. While the number of taps per bit required is 49 and the number of types of taps is 23 in the above described first embodiment, the second embodiment can reduce the number of taps to 21 and reduce the number of types of taps to 11 respectively.

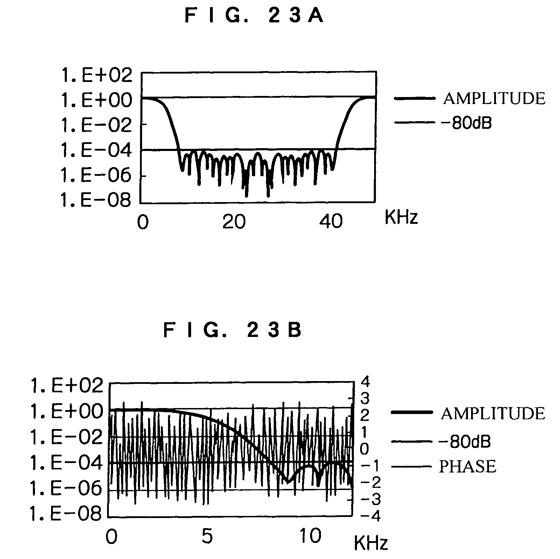

Fig. 23A and 23B are diagrams showing the frequency characteristic of the low-pass filter structured as shown in Fig. 22 and expresses the gain on a logarithmic scale. Fig. 23B is a partially enlarged view of the characteristic shown in Fig. 23A. As is evident from a comparison between this Fig. 23 and the above described Fig. 20, even when a low-pass filter is constructed as shown in Fig. 22, it is possible to obtain a frequency characteristic of substantially the same level as that of Fig. 20.

Here, an example of the structure of the low-pass filter has been shown, but it is likewise possible to construct a high-pass filter or band pass filter, etc. , using a loop circuit and this can further reduce the number of taps to be used.

The apparatus for realizing the digital filter design method according to the above described first and second embodiments can be realized using any one of a hardware structure, DSP and software. For example, when the apparatus is realized by software, the filter design device can be constructed of a CPU or MPU, RAM, ROM, etc., of a computer and the device can be realized by operating a program stored in a RAM, ROM or hard disk, etc.

Therefore, the device can be realized by recording a program that causes a computer to operate so as to perform the functions of this embodiment in a recording medium such as a CD-ROM and causing the computer to read this program. As the recording medium for recording the above described program, it is possible to use a flexible disk, hard disk, magnetic tape, optical disk, magneto-optical disk, DVD, non-volatile memory card, etc., in addition to CD-ROM. Furthermore, it is also possible to realize this embodiment by downloading the above described program to a computer through a network such as the Internet.

That is, it is possible to store filter coefficients related to various types of unit filter as information in a memory such as RAM or ROM and when the user instructs an arbitrary combination related to unit filters, it is possible to allow the CPU to calculate filter coefficients corresponding to the instructed combination using the information of filter coefficients stored in the above described memory to obtain an FIR filter.

For example, it is also possible to iconize various types of unit filters (which store filter coefficients corresponding to various icons as information) and allow the user to arbitrarily combine these icons arbitrarily on a display screen and allow the CPU to automatically calculate and obtain filter coefficients corresponding to the sequence thereof. Furthermore, if the calculated filter coefficients are automatically FFT-transformed and the result is displayed as a frequency-gain characteristic, it is possible to check the designed filter characteristic and perform filter design more easily.

Here, in not only the case where the functions of the above described embodiment are realized by the computer executing a supplied program but also a case where the functions of the above described embodiment are realized by the program operating in cooperation with the OS (operating system) operating on the computer or other application software, etc. , or a case where the functions of the above described embodiment are realized when the whole or part of processing of the supplied program are implemented by a function expansion board or function expansion unit of the computer, such a program is included in the embodiment of the present invention.

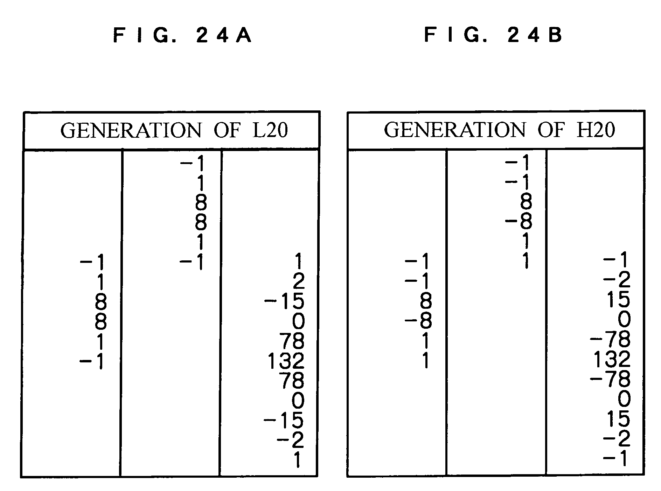

The above described first and second embodiment, the symmetric numerical sequence shown in FIGS. 2A and 2B is divided into two parts and used as filter coefficients of an asymmetric 3-tap unit filter, but the original symmetric numerical sequence is not limited to this. For example, it is also possible to use the symmetric numerical sequences of the 5-tap low-pass unit secondary filter L20 generated as shown in FIG. 24A or 5-tap high-pass unit secondary filter H20 generated as shown in FIG. 24B.

Furthermore, in addition to those shown in FIG. 2 and FIG. 24 above, it is also possible to use numerical values whose absolute values are "1" and "8" , use a numerical sequence different from the above described numerical sequences as filter coefficients of a 5-tap unit filter, divide the numerical sequence into two parts and use them as filter coefficients of a 3-tap unit filter.

Furthermore, it should be noted that the above described embodiments show only examples of implementing the present invention and the technical scope of the present invention should not be thereby interpreted in a limited way. That is, the present invention can be implemented in various modes without departing from the spirit or major features thereof.

### [Industrial Applicability]

The present invention is effectively applicable to a type of FIR digital filter provided with tapped delay lines made up of a plurality of delayers, whereby signals of the respective taps are multiplied several-fold, added up the results of multiplication and output the addition result.

## Claims

1. A method of designing a digital filter by multiplying signals of taps of a tapped delay line made up of a plurality of delayers several-fold according to given filter coefficients, adding up the results of multiplication and outputting the addition result, comprising:
carrying out a filter design using a basic filter formed by cascade connecting first and second unit filters so that the numerical sequence as a whole is symmetric;
said first and second unit filters have asymmetric filter coefficients of numerical sequences whose values are set in such a way that the total values of the respective numerical sequences are non-zeros and the total values of every other values of the numerical sequences match and have the same signs.

2. The digital filter design method according to claim 1,
said asymmetric filter coefficients making up said first and second unit filters are formed by dividing a predetermined symmetric numerical sequence at the center into two parts and further adjusting the numerical sequences on both sides; and
the values of said predetermined symmetric numerical sequence are set in such a way that the total value of the numerical sequence is non-zero and the total value of every other values of said numerical sequence match and have the same sign.

3. The digital filter design method according to claim 2,
said predetermined symmetric numerical sequence is formed in a ratio of -1, 0, 9, 16, 9, 0, -1; and
said asymmetric filter coefficients form numerical sequences in ratios of -(1-N/8), 0, (9-N/8), 8 and 8, (9-N/8), 0, -(1-N/8) (N: 0≤N≤8).

4. A method of designing a digital filter by multiplying signals of taps of a tapped delay line made up of a plurality of delayers several-fold according to given filter coefficients, adding up the results of multiplication and outputting the addition result, comprising:
carrying out a filter design using a basic filter formed by cascade connecting first and second unit filters so that the numerical sequence as a whole is symmetric;
said first and secondunit filters have asymmetric filter coefficients of numerical sequences whose values are set in such a way that the total values of the respective numerical sequences are zeros and the total values of every other values of said numerical sequences match and have the opposite signs.

5. The digital filter design method according to claim 4,
asymmetric filter coefficients making up said first and second unit filters are formed by dividing a predetermined symmetric numerical sequence at the center into two parts and further adjusting the numerical sequences on both sides; and the values of said predetermined symmetric numerical sequence are set in such a way that the total value of the numerical sequence is zero and the total value of every other values of said numerical sequence match and have the opposite sign.

6. The digital filter design method according to claim 5,
said predetermined symmetric numerical sequence is formed in a ratio of 1, 0, -9, 16, -9, 0, 1; and
said asymmetric filter coefficients form numerical sequences in ratios of (1-N/8), 0, -(9-N/8), 8 and 8, -(9-N/8), 0, (1-N/8) (N: 0≤N≤8).

7. The digital filter design method according to any one of claims 1 to 6,
pass frequency band of a filter is adjusted by inserting delays of n clocks between taps corresponding to the asymmetric filter coefficients making up said first and second unit filters.

8. A digital filter design device, comprising:
basic filter storing means for storing information related to a basic filter formed by cascade connecting first and second unit filters in such a way that the numerical sequence as a whole is symmetric, said first and second unit filters have asymmetric filter coefficients of a numerical sequence whose values are set so that the total values of the numerical sequences are non-zeros and the total values of every other values of said numerical sequences match and have the same signs;
cascade connecting means for instructing the number of said basic filters cascade connected; and
filter coefficient calculating means for calculating filter coefficients corresponding to the number of filters cascade connected instructed by said cascade connecting means using information stored by said basic filter storing means.

9. A digital filter design device, comprising:
basic filter storing means for storing information related to a basic filter formed by cascade connecting first and second unit filters in such a way that the numerical sequence as a whole is symmetric, said first and second unit filters have asymmetric filter coefficients of a numerical sequence whose values are set so that the total values of the respective numerical sequences are zeros and the total values of every other values of said numerical sequences match and have the opposite signs;
cascade connecting means for instructing the number of said basic filters cascade connected; and
filter coefficient calculating means for calculating filter coefficients corresponding to the number of filters cascade connected instructed by said cascade connecting means using information stored by said basic filter storing means.

10. The digital filter design device according to claim 8 or 9, comprising:
delay means for adjusting pass frequency band of a filter by inserting delays of n clocks between taps corresponding to the asymmetric filter coefficients making up said first and second unit filters.

11. A digital filter, comprising:
a tapped delay line made up of a plurality of delayers;
coefficient multipliers which multiply signals of taps several-fold by filter coefficients calculated using the filter design method according to any one of claims 1 to 7;
adders which added up the multiplication results and output the addition result.

12. A digital filter including a tapped delay line made up of a plurality of delayers, which multiplies signals of taps several-fold according to given filter coefficients, adds up the multiplication results and outputs the addition result, comprising:
forming a basic filter by cascade connecting first and second unit filters so that the numerical sequence as a whole is symmetric, said first and second unit filters have asymmetric filter coefficients of numerical sequences whose values are set in such a way that the total values of the respective numerical sequences are non-zeros and the total values of every other values of the numerical sequences match and have the same sign; and
cascade connecting a plurality of said basic filters.

13. The digital filter according to claim 12,
said asymmetric filter coefficients making up said first and second unit filters are formed by dividing a predetermined symmetric numerical sequence at the center into two parts and further adjusting the numerical sequences on both sides; and
the values of said predetermined symmetric numerical sequence are set in such a way that the total value of the numerical sequence is non-zero and the total value of every other values of said numerical sequence match and have the same sign.

14. The digital filter according to claim 13,
said predetermined symmetric numerical sequence is formed in a ratio of -1, 0, 9, 16, 9, 0, -1.

15. The digital filter according to claim 14,
said asymmetric filter coefficients making up said first and second unit filters form numerical sequences in ratios of -(1-N/8), 0, (9-N/8), 8 and 8, (9-N/8), 0, -(1-N/8) (N: 0≤N≤8).

16. A digital filter including a tapped delay line made up of a plurality of delayers, which multiplies signals of taps several-fold according to given filter coefficients, adds up the multiplication results and outputs the addition result, comprising:
forming a basic filter by cascade connecting first and second unit filters so that the numerical sequence as a whole is symmetric, said first and second unit filters have asymmetric filter coefficients of numerical sequences whose values are set in such a way that the total values of the respective numerical sequences are zeros and the total values of every other values of the numerical sequences match and have the opposite signs; and
cascade connecting a plurality of said basic filters.

17. The digital filter according to claim 16,
said asymmetric filter coefficients making up said first and second unit filters are formed by dividing a predetermined symmetric numerical sequence at the center into two parts and further adjusting the numerical sequences on both sides; and
the values of said predetermined symmetric numerical sequence are set in such a way that the total value of the numerical sequence is zero and the total value of every other values of said numerical sequence match and have the opposite sign.

18. The digital filter according to claim 17,
said predetermined symmetric numerical sequence is formed in a ratio of 1, 0, -9, 16, -9, 0, 1.

19. The digital filter according to claim 18,
said asymmetric filter coefficients making up said first and second unit filters form numerical sequences in ratios of (1-N/8), 0, -(9-N/8), 8 and 8, -(9-N/8), 0, (1-N/8) (N: 0≤N≤8).

20. The digital filter according to any one of claims 12 to 19, comprising:
delay means for inserting delays of n clocks between taps corresponding to said asymmetric filter coefficients making up said first and second unit filters.

21. A digital filter design program for causing a computer to execute processing steps related to the filter designmethod according to any one of claims 1 to 7.

22. A digital filter design program for causing a computer to function as the means according to any one of claims 8 to 10.
